(19) Europäisches Patentamt
European Patent Office
Office européen des brevets

(11) EP 1 000 948 B1

(12) EUROPEAN PATENT SPECIFICATION

(45) Date of publication and mention of the grant of the patent:
**04.09.2002 Bulletin 2002/36**

(51) Int Cl.[7]: **C07F 1/08**, C23C 16/18

(21) Application number: **99308237.9**

(22) Date of filing: **19.10.1999**

(54) **Copper containing substituted phenylethylene precursor and synthesis method**

Kupferhaltige substituierte Phenylethylenvorläuferverbindung und Verfahren zur Herstellung

Précurseurs à base de phénylethylène substitué et cuivre, et procédé pour le préparer

(84) Designated Contracting States:
**DE FR GB**

(30) Priority: **11.12.1998 US 210099**
**10.11.1998 US 107892 P**

(43) Date of publication of application:
**17.05.2000 Bulletin 2000/20**

(73) Proprietor: **SHARP KABUSHIKI KAISHA**
**Osaka 545-8522 (JP)**

(72) Inventors:
- **Zhuang, Wei Wei**
**Vancouver, WA 98683 (US)**
- **NGuyen, Tue**
**Vancouver, WA 98683 (US)**
- **Charneski, Lawrence J.**
**Vancouver, WA 98682 (US)**
- **Evans, David R.**
**Beaverton, OR 97007 (US)**
- **Hsu, Sheng Teng**
**Camas, WA 98607 (US)**

(74) Representative: **West, Alan Harry**
**R.G.C. Jenkins & Co.**
**26 Caxton Street**
**London SW1H 0RJ (GB)**

(56) References cited:
**US-A- 5 085 731**

- **DOYLE, G. ET AL.: "alkene and carbon monoxide derivatives of copper(I) and silver(I) .beta.-diketonates" ORGANOMETALLICS, vol. 4, no. 5, 1985, pages 830-835, XP000892470**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 000 948 B1

Printed by Jouve, 75001 PARIS (FR)

## Description

This invention relates generally to integrated circuit processes and fabrication, and more particularly, to a precursor and synthesis method, having a substituted phenylethylene ligand, such as $\alpha$ - methylstyrene, which improves liquid phase stability, and which is capable of depositing copper at high deposition rates, low resistivity, and with good adhesion on selected integrated circuit surfaces.

The demand for progressively smaller, less expensive, and more powerful electronic products, in turn, fuels the need for smaller geometry integrated circuits (ICs) on larger substrates. It also creates a demand for a denser packaging of circuits onto IC substrates. The desire for smaller geometry IC circuits requires that the interconnections between components and dielectric layers be as small as possible. Therefore, research continues into reducing the width of via interconnects and connecting lines. The conductivity of the interconnects is reduced as the area of the interconnecting surfaces is reduced, and the resulting increase in interconnect resistivity has become an obstacle in IC design. Conductors having high resistivity create conduction paths with high impedance and large propagation delays. These problems result in unreliable signal timing, unreliable voltage levels, and lengthy signal delays between components in the IC. Propagation discontinuities also result from intersecting conduction surfaces that are poorly connected, or from the joining of conductors having highly different impedance characteristics.

There is a need for interconnects and vias to have both low resistivity, and the ability to withstand process environments of volatile ingredients. Aluminum and tungsten metals are often used in the production of integrated circuits for making interconnections or vias between electrically active areas. These metals are popular because they are easy to use in a production environment, unlike copper which requires special handling.

Copper (Cu) would appear to be a natural choice to replace aluminum in the effort to reduce the size of lines and vias in an electrical circuit. The conductivity of copper is approximately twice that of aluminum and over three times that of tungsten. As a result, the same current can be carried through a copper line having nearly half the width of an aluminum line.

The electromigration characteristics of copper are also much superior to those of aluminum. Aluminum is approximately ten times more susceptible than copper to degradation and breakage due to electromigration. As a result, a copper line, even one having a much smaller cross-section than an aluminum line, is better able to maintain electrical integrity.

There have been problems associated with the use of copper, however, in IC processing. Copper pollutes many of the materials used in IC processes and, therefore barriers are typically erected to prevent copper from migrating. Elements of copper migrating into these semiconductor regions can dramatically alter the conduction characteristics of associated transistors. Another problem with the use of copper is the relatively high temperature needed to deposit it on, or removing it from, an IC surface. These high temperatures can damage associated IC structures and photoresist masks.

It is also a problem to deposit copper onto a substrate, or in a via hole, using the conventional processes for the deposition of aluminum when the geometries of the selected IC features are small. That is, new deposition processes have been developed for use with copper, instead of aluminum, in the lines and interconnects of an IC interlevel dielectric. It is impractical to sputter metal, either aluminum or copper, to fill small diameter vias, since the gap filling capability is poor. To deposit copper, first, a physical vapor deposition (PVD), and then, a chemical vapor deposition (CVD) technique, have been developed by the industry.

With the PVD technique, an IC surface is exposed to a copper vapor, and copper is caused to condense on the surfaces. The technique is not selective with regard to surfaces. When copper is to be deposited on a metallic surface, adjoining non-conductive surfaces must either be masked or etched clean in a subsequent process step. As mentioned earlier, photoresist masks and some other adjoining IC structures are potentially damaged at the high temperatures at which copper is processed. The CVD technique is an improvement over PVD because it is more selective as to which surfaces copper is deposited on. The CVD technique is selective because it is designed to rely on a chemical reaction between the metallic surface and the copper vapor to cause the deposition of copper on the metallic surface.

In a typical CVD process, copper is combined with a ligand, or organic compound, to help insure that the copper compound becomes volatile, and eventually decomposes, at consistent temperatures. That is, copper becomes an element in a compound that is vaporized into a gas, and later deposited as a solid when the gas decomposes. Selected surfaces of an integrated circuit, such as diffusion barrier material, are exposed to the copper gas, or precursor, in an elevated temperature environment. When the copper gas compound decomposes, copper is left behind on the selected surface. Several copper gas compounds are available for use with the CVD process. It is generally accepted that the configuration of the copper gas compound, at least partially, affects the ability of the copper to be deposited on to the selected surface.

Copper metal thin films have been prepared via chemical vapor deposition by using many different kinds of copper precursors. In 1990, D. B. Beach et al. *Chem. Mater*. (2) 216 (1990) obtained pure copper films via CVD by using $(\eta^5\text{-}C_5H_5)Cu(PMe_3)$, and later, in 1992, H. K. Shin et al., *Chem. Mater*. (4) 788 (1992) declared the same results

by using (hfac)Cu$(PR_3)_n$ (R = methyl and ethyl and $n$ = 1 and 2). However, these copper precursors are solids, which can not be used in the liquid delivery system for copper thin film CVD processing. Furthermore, the copper films often contain contamination of carbon and phosphorus, which can not be used as interconnectors in microprocessors.

$Cu^{2+}(hfac)_2$, or copper (II) hexafluoroacetylacetonate, precursors have previously been used to apply CVD copper to IC substrates and surfaces. However, these $Cu^{2+}$ precursors are notable for leaving contaminates in the deposited copper, and for the relatively high temperatures that must be used to decompose the precursor into copper.

The studies of copper precursors conducted in the early of 1990's were concentrated on the evaluation of a series of copper(I) fluorinated β-diketonate complexes, which have been proven to be very promising sources for the use in the chemical vapor deposition of copper metal thin films. Copper(I) fluorinated β-diketonate complexes were first synthesized by Gerald Doyle, U.S. Pat. No. 4,385,005 (1983) and 4,425,281 (1984), in which he presented the synthesis method and their application in the separation of unsaturated organic hydrocarbons. In the U.S. Pat. No. 5,096,737 (1992), Thomas H. Baum, et at., claimed the application of these copper(I) fluorinated β-diketonate complexes as copper precursors for CVD copper thin film preparation. Copper thin films have been prepared via chemical vapor deposition using these precursors.

Among several liquid copper precursors, 1,5-dimethyl 1,5-cyclooctadiene copper(I) hexafluoroacetylacetonate mixed with 1,6-dimethyl 1,5-cyclooctadiene copper(I) hexafluoroacetylacetonate ((DMCOD)Cu(hfac)) and hexyne copper(I) hexafluoroacetylacetonate ((HYN)Cu(hfac) were evaluated in detail. The copper thin films deposited using (DMCOD)Cu(hfac) have very good adhesion to metal or metal nitride substrates, but a high resistivity (2.5 $\mu\Omega\cdot$cm) and a low deposition rate. (HYN)Cu(hfac) copper film has poor adhesion to a TiN substrate, and high resistivity (~ 2.1 $\mu\Omega\cdot$cm). Another compound, butyne copper(I)(hfac), ((BUY)Cu(hfac)), gives a copper film with low resistivity (1.93 $\mu\Omega$ cm), but has poor adhesion and is relatively expensive. Also, the compound is a solid and, therefore, difficult to use in a liquid delivery system. The invention of copper(I)(hfac) stabilized with a series of trialkylvinylsilane (John A. T. Norman et al., U.S. Pat. No. 5,085,731 (1992)) improved the properties of copper thin films.

Copper films deposited using a liquid copper precursor, (hfac)Cu(TMVS), where TMVS = trimethylvinylsilane, have low resistivities and reasonably adhesion to substrates. This precursor is useful because it can be used at relatively low temperatures, approximately 200°C. This liquid copper precursor has been used for the preparation of copper metal thin films via CVD for some time, but there are still some drawbacks: stability, the adhesion of copper films, and cost for the trimethylvinylsilane stabilizer. Also, the precursor is not especially stable, and can have a relatively short shelf life if not refrigerated. Various ingredients have been added to (hfac)Cu(tmvs) to improve its adhesiveness, temperature stability, and the rate at which it can be deposited on an IC surface. U.S. Patent 5,744,192, entitled "Method Of Using Water To Increase The Conductivity Of Copper Deposited With Cu(HFAC)TMVS", invented by Nguyen et al., discloses a precursor and method of improving the electrical conductivity of Cu deposited with (hfac)Cu(tmvs).

It is generally acknowledged in the industry that (hfac)Cu(tmvs) becomes unstable, and begins to decompose, above 35° C. Use of a (hfac)Cu(tmvs) precursor stored at this temperature leads to undesirable process results. The effectivity of(hfac)Cu(tmvs) stored at temperatures lower than 35° C is also unpredictable. A "fresh" batch of precursor, or precursor stored at temperatures well below room temperature, is used to guarantee predictable processes.

A Cu precursor comprising a ligand of methoxy and methyl groups is disclosed in co-pending U.S. Patent 6,090,960 filed Jan. 7, 1997, entitled "Precursor with (Methoxy)(methyl)silylolefin Ligands to Deposit Cu and Method for Same", invented by Senzaki et al., and assigned to the same assignee as the instant patent. The disclosed precursor permits either one or two methoxy groups to be bonded to the silicon atom of the ligand. That is, the precursor can be "fine tuned" using ligands having more methoxy groups than tmvs, but less than tmovs are provided. The oxygen atoms in the methoxy groups contribute electrons to the Cu atoms, to strengthen the Cu-olefin bond, and so, prevent the premature decomposition of the precursor in storage, or as the precursor is heated for the application of Cu to an IC surface. However, only hydrocarbon groups of one carbon atom, $CH_3$ (methyl) and $OCH_3$ (methoxy), are disclosed.

A Cu precursor comprising a ligand of alkyl and alkyl groups is disclosed in U.S. Patent 5,767,301, entitled "Precursor with (Alkyloxy)(Alkyl)silylolefin Ligands to Deposit Copper", invented by Senzaki et al. The disclosed precursor describes alkyl groups bonded to the silicon atom of the ligand with alkoxyl groups. However, the search continues for even more effective copper precursors.

It would be advantageous if a copper precursor was found that effectively deposits copper with low resistivity and good adhesion properties. It would be further advantageous if this precursor was inexpensive to synthesize.

It would be advantageous if a method were found of making a Cu(hfac) precursor stable over a wider range of temperatures, and to provide that the precursor remain in liquid phase during storage.

It would also be advantageous if water, H-hfac, H-hfac dihydrate (H-hfac$\cdot 2H_2O$) were no longer necessary to blend with a Cu precursor to improve the thermal stability of the Cu precursor.

Accordingly, a volatile copper (Cu) precursor compound for the chemical vapor deposition (CVD) of copper (Cu) to selected surfaces is provided. The precursor compound comprises:

$Cu^{+1}$(hexafluoroacetylacetonate); and

a substituted phenylethylene ligand including one phenyl group bonded to a first carbon atom, with the remaining bond to said first carbon atom being selected from a first group consisting of $C_1$ to $C_6$ alkyl, $C_1$ to $C_6$ haloalkyl, $C_1$ to $C_6$ phenyl, and $C_1$ to $C_6$ alkoxyl, and in which a second carbon atom includes a second and third bond. The second and third bonds are selected, independent of each other, from the group consisting of H, $C_1$ to $C_6$ alkyl, $C_1$ to $C_6$ phenyl, and $C_1$ to $C_6$ alkoxyl. In this manner, a stable precursor capable of high Cu deposition rates is formed.

Preferably, the first bond is $H_3C$, the second bond is H, and the third bond is H, whereby an $\alpha$ - methylstyrene ligand is formed. To further enhance the liquid phase stability of the precursor the compound includes an additive to create a precursor blend. The precursor blend further comprises:

less than approximately 10% substituted phenylethylene, as measured by weight ratio of the precursor compound, to facilitate a stable liquid phase precursor. The same substituted phenylethylene ligand, used to form the precursor compound, is used as the additive.

A method for synthesizing a copper(hfac) substituted phenylethylene precursor is also provided. The method comprises the steps of:

a) forming a uniformly mixed solution of $Cu_2O$ in a solvent;
b) introducing a substituted phenylethylene, preferably $\alpha$ - methylstyrene, to the solution of Step a), and forming a uniformly mixed solution;
c) introducing hexafluoroacetylacetone (hfac) to the solution of Step b), and forming a uniformly mixed solution;
d) filtering the solution to remove solid materials, whereby any excess $Cu_2O$ is removed;
e) removing the solvent from the solution;
f) stirring until any crystallized precursor in the solution is dissolved;
g) letting the solution stand until solid material precipitates; and
h) filtering to remove the solid material, whereby a liquid phase precursor is formed.

Specifically, Step a) includes the $Cu_2O$ being, in proportion, 0.210 mol, Step b) includes the substituted phenylethylene being, in proportion, 0.292 mol, and Step c) includes the hfac being, in proportion, 0.292 mol.
To insure improved liquid phase stability, the method comprises a further step, following Step h), of:

i) adding less than approximately 10%, by weight ratio, of the substituted phenylethylene used in Step b) to the solution. Preferably, Step i) includes adding approximately 5% substituted phenylethylene.

A second, preferred synthesis method, specific to the synthesis of an $\alpha$ - methylstyrene ligand precursor, is provided comprising the steps of:

a) forming a uniformly mixed solution of $Cu_2O$ and solvent;
b) introducing $\alpha$ - methylstyrene to the solution of Step a), and forming a uniformly mixed solution;
c) introducing hexafluoroacetylacetone to the solution of Step b), and forming a uniformly mixed solution;
d) filtering the solution to remove solid material in the solution, whereby excess $Cu_2O$ is removed;
e) stripping the solution of solvent; and
f) filtering the solution to remove solid material and crystallized compounds, whereby a liquid phase stable precursor is formed.

Specifically, Step a) includes $Cu_2O$ being proportionally 0.91 mol, Step b) includes $\alpha$ - methylstyrene being proportionally 0.142 mol, and Step c) includes the hfac being proportionally 0.136 mol.
Fig. 1 is a schematic representation of the present invention precursor with a substituted phenylethylene ligand.
Fig. 2 is a schematic representation of a substituted phenylethylene ligand.
Fig. 3 is a schematic representation of the preferred embodiment $\alpha$ - methylstyrene ligand.
Fig. 4 is a flowchart illustrating steps in a method for synthesizing a copper(hfac) substituted phenylethylene precursor.
Fig. 5 is a flowchart illustrating a preferred method for synthesizing a copper(hfac)$\alpha$ - methylstyrene precursor.
The substituted phenylethylene ligand copper precursor, disclosed below, is inexpensive to synthesize. Compared to trimethylvinylsilane, which costs approximately $165 per 100 g, $\alpha$- methylstyrene is inexpensive, at approximately $0.60 per 100 g. The precursor is stable at room temperature for easy storage and handling. Despite retaining

its liquid phase at room temperature, it is highly volatile at higher temperatures. Therefore, no decomposition occurs in the CVD liquid delivery line and vaporizer, which requires precursor stability at 90 degrees C, under vacuum, for four minutes. Further, the precursor has excellent adhesion to metal and metal nitride substrates, such as W, Ti, TiN, Ta, TaN, Al, Pt, WN, and similar barrier materials. The copper deposited with precursor has low resistivity (< 1.9 $\mu\Omega\cdot$cm), high electromigration resistance, and excellent conformality to severe surface morphology.

Fig. 1 is a schematic representation of the present invention precursor with a substituted phenylethylene ligand. Volatile copper (Cu) precursor compound 10 is used for the chemical vapor deposition (CVD) of copper (Cu) to selected surfaces. Precursor compound 10 comprises $Cu^{+1}$(hexafluoroacetylacetonate) and a substituted phenylethylene ligand.

Fig. 2 is a schematic representation of substituted phenylethylene ligand 20. Substituted phenylethylene ligand 20 includes one phenyl group bonded to a first carbon atom, with the remaining bond to the first carbon atom being selected from a first group of potential molecules represented by $R^1$. The $R^1$ group consists of $C_1$ to $C_6$ alkyl, $C_1$ to $C_6$ haloalkyl, $C_1$ to $C_6$ phenyl, and $C_1$ to $C_6$ alkoxyl. The second carbon atom includes a second and third bond selected, respectively, from a second and third group of molecules represented by $R^2$ and $R^3$. The second and third bonds, $R^2$ and $R^3$, are selected from the group consisting of H, $C_1$ to $C_6$ alkyl, $C_1$ to $C_6$ phenyl, and $C_1$ to $C_6$ alkoxyl. The second and third bonds ($R^2$ and $R^3$) vary independently from each other. In this manner, a stable precursor capable of high Cu deposition rates is formed.

Fig. 3 is a schematic representation of the preferred embodiment $\alpha$ - methylstyrene ligand 30. First bond ($R^1$) is $H_3C$, the second bond ($R^2$) is H, and the third bond ($R^3$) is H, whereby an $\alpha$ - methylstyrene ligand is formed.

To improve and facilitate a stable liquid phase precursor, in some aspects of the invention, compound 10 includes an additive to create a precursor blend. The precursor blend further comprises:

less than approximately 10% substituted phenylethylene 20 (see Fig. 2), as measured by weight ratio of the precursor compound.

Volatile copper (Cu) precursor compound 10 is alternately represented with the following structural formula:

$$(hfac)Cu(C_6H_5)(R^1)C{=}C(R^2)(R^3)$$

in which $R^1$ is selected from the group consisting of $C_1$ to $C_6$ alkyl, $C_1$ to $C_6$ haloalkyl, $C_1$ to $C_6$ phenyl, and $C_1$ to $C_6$ alkoxyl;
in which $R^2$ is selected from the group consisting of H, $C_1$ to $C_6$ alkyl, $C_1$ to $C_6$ phenyl, and $C_1$ to $C_6$ alkoxyl; and in which $R^3$ is selected from the group consisting of H, $C_1$ to $C_6$ alkyl, $C_1$ to $C_6$ phenyl, and $C_1$ to $C_6$ alkoxyl, whereby a precursor is formed from a substituted phenylethylene ligand.

Preferably, $R^1$ is $H_3C$, in which $R^2$ is H, and $R^3$ is H, whereby an $\alpha$ - methylstyrene ligand is formed.

In some aspects of the invention, the compound includes an additive to create a Cu precursor blend, the blend further comprising the substituted phenylethylene has the following structural formula:

$$(C_6H_5)(R^1)C{=}C(R^2)(R^3)$$

in which $R^1$ is selected from the group consisting of $C_1$ to $C_6$ alkyl, $C_1$ to $C_6$ haloalkyl, $C_1$ to $C_6$ phenyl, and $C_1$ to $C_6$ alkoxyl;
in which $R^2$ is selected from the group consisting of H, $C_1$ to $C_6$ alkyl, $C_1$ to $C_6$ phenyl, and $C_1$ to $C_6$ alkoxyl; and in which $R^3$ is selected from the group consisting of H, $C_1$ to $C_6$ alkyl, $C_1$ to $C_6$ phenyl, and $C_1$ to $C_6$ alkoxyl, whereby the precursor is further stabilized in a liquid phase.

Typically, the additive is less than approximately 10% by weight ratio of the precursor blend. The substituted phenylethylene ligand selected to form the precursor is the same substituted phenylethylene ligand used as the additive to form the precursor blend. That is, when the precursor uses an $\alpha$ - methylstyrene ligand, the additive is also an $\alpha$ - methylstyrene.

The above-described copper precursor is synthesized by two different methods. The prior art (Doyle) synthesis procedures proved unsatisfactory. The reaction between $Cu_2O$, 1,1,1,5,5,5-hexafluoroacetylacetone and $\alpha$-methylstyrene, in making $\alpha$-methylstyrene copper(I) hexafluoroacetylacetonate (($\alpha$-MS)Cu(hfac)) in dichloromethane, produces a half-liquid, half-crystalline solid. The solid portion is unsuitable for delivery in a vaporization process and must be removed. Further, in the separated liquid portion, small crystals are continually precipitated at room temperature over

time. To remedy this situation, the published synthesis route was modified to create two new synthesis methods.

First, the product synthesized from the published method was strongly stirred for ten hours at room temperature until all of the small crystals disappeared, then the liquid product was let to stand for twelve hours. During this period, large crystals were formed. The liquid portion was separated from the large crystals by filtration (1 μm pore size). Then, 5% (w/w) α-methylstyrene was added into the liquid as a stabilizer. By using this method, a very phase stable copper liquid precursor was obtained, but the yield was not high, at about 40%. After standing for a month, no crystal precipitate was observed in the stabilized liquid source.

Fig. 4 is a flowchart illustrating steps in a method for synthesizing a copper(hfac) substituted phenylethylene precursor. Step 100 provides $Cu_2O$. Step 102 forms a uniformly mixed solution of $Cu_2O$ in a solvent. Step 102 includes using a solvent selected from the group consisting of dichloromethane and tetrahydrofuran (THF), although dichloromethane is preferred. Step 104 introduces a substituted phenylethylene to the solution of Step 102, and forms a uniformly mixed solution. In the preferred embodiment, Step 104 includes the substituted phenylethylene being α -methylstyrene. Step 106 introduces hexafluoroacetylacetone (hfac) to the solution of Step 104, and forms a uniformly mixed solution.

Step 108 filters the solution to remove solid materials, whereby any excess $Cu_2O$ is removed. It is typical to add excess $Cu_2O$ to the procedure. $Cu_2O$ is inexpensive and an excess amount produces a higher yield of precursor. At this step in the process other solids such as impurities are removed. In some aspects of the invention celite ($SiO_2$) is used to filter the solution. Often celite is used in addition to a ceramic filter having pore diameters in the range between 10 and 25 μm. Therefore, Step 108 includes removing solid material larger than approximately 10 μm.

Step 110 removes the solvent from the solution. Step 112 stirs the remaining solution until any crystallized precursor in the solution is dissolved. Even in relatively small batches this stirring may take ten hours to accomplish. Step 114 lets the solution stand until crystals form. In some aspects of the invention, Step 114 includes letting the solution stand until crystals having a size in the range from 2 to 4 millimeters are formed. This step takes approximately twelve hours in some aspects of the invention. Step 116 filters to remove the solid material. Step 116 includes filtering solid material having a size greater than approximately 1 μm. In small batches, a 1 μm size filter on a syringe opening, was used to extract the solution. Step 118 is a product, a liquid phase precursor.

In some aspects of the invention, Step a) includes the $Cu_2O$ being, in proportion, 0.210 mol, Step b) includes the substituted phenylethylene being, in proportion, 0.292 mol, and Step c) includes the hfac being, in proportion, 0.292 mol. By maintaining the above-described proportions, precursor is made in batches of any size.

In some aspects of the invention, a further step follows Step 116. Step 116a (not shown) adds less than approximately 10%, by weight ratio, of the substituted phenylethylene used in Step 104 to the solution, whereby the liquid phase stability of the precursor is improved. Preferably, Step 116a includes adding approximately 5% substituted phenylethylene.

To improve the yield, a second synthesis method was developed, in which extra α-methylstyrene was introduced into reaction. In this way, the yield has been increased to about 87%.

All manipulations were carried out in an air-free dry glovebox or by using standard Schlenk techniques. Solvents were purified before synthesis. Dichloromethane and α-methylstyrene were refluxed and distilled over calcium hydride under an atmosphere of nitrogen prior to use. 1,1,1,5,5,5-hexafluoroacetylacetone was purchased from Strem , and used directly without any purification.

The synthesis procedure of organometallic copper(I) complexes was first described by Doyle in U.S. Pat. No. 4,385,005, in which copper monoxide reacted with unsaturated organic hydrocarbon and 1,1,1,5,5,5-hexafluoroacetylacetone in dichloromethane or THF. The reaction is described by the following equation:

$$Cu_2O + 2\,(CF_3)C(O)CH_2C(O)(CF_3) + 2\,L \xrightarrow{CH_2Cl_2 \text{ or } THF} 2\,Cu(hfac)(L)$$

where L is unsaturated organic hydrocarbon ligand.

According to the synthesis procedure above, the synthesis of (α-MS)Cu(hfac) gives the product containing both liquid and crystalline solid phases. By filtration, the liquid portion was easily separated from the solid. After twelve hours, some small crystals precipitated from the liquid. The NMR studies indicated the liquid part of the compound being Cu(hfac)(α-MS), which is expected, whereas the solid is an unknown compound, which is still under investigation. To improve the yield of liquid compound, Doyle's synthesis procedure was modified by introducing 5 to 10% extra α-methylstyrene (α-MS) into reaction. By this modified synthesis procedure, pure liquid Cu(hfac)(α-MS) is obtained with a high yield.

In the synthesis of Cu(hfac)(α-MS), $Cu_2O$ (13.0 g, 0.091 mol) was added into a 100 ml round bottom flask equipped with $CH_2Cl_2$ (50 ml) and a stirring bar. To this $Cu_2O$ dichloromethane solution, α-methylstyrene (18.5 ml,

0.142 mol) was added and stirred at room temperature for ten minutes. Then 1,1,1,5,5,5-hexafluoroacetylacetone (19.2 ml, 0.136 mol) was slowly introduced into this red color solution with stirring. After 5 minutes, the solution color gradually changed to green. The green solution was continually stirred for another 10 minutes, and then filtered through celite. The green filtrate was stripped under vacuum for four hours and then heated to 35 °C under vacuum for another half-hour stripping. This produced a green liquid organometallic copper compound, which was then filtered through a fine filter (1 μm) to give 49.19 grams of product (yield: 87.38%).

The calculation of yield was carried out as follows. Because of the high boiling point of α-methylstyrene, it was assumed that no α-methylstyrene was lost. Then, X is set to be the weight of free α-methylstyrene in product, Y, the weight of Cu(hfac)(α-MS), and A , the total weight of product. The following equations result:

$$X + Y = A$$

$$Y = (388.73)/118.18) \times (18.5 \times 0.909 - X)$$

where the molecular weight of Cu(hfac)(α-MS) and α-methylstyrene are 388.73 and 118.18 respectively, and the density of α-methylstyrene is 0.909 g/ml. Thus, we have

$Y = 1.4368(A - 18.5 \times 0.909)$ (when A = 49.19, then Y = 46.511) and yield = $(Y/53.23)\cdot 100\% = 87.38\%$.

The primary investigation on the properties of Cu(hfac)(α-MS) has been summarized as follows:

1) density is about 1.3 g/ml;
2) with the addition of 5% extra α-methylstyrene as stabilizer, Cu(hfac)(α-MS) is stable at room temperature without any crystal or solid precipitation, at 75 degrees C under vacuum (0.02 mmHg), the compound is stable for three hours and then very slowly starts decomposition with the precipitation of copper metal, and at 100 degrees C under vacuum (0.02 mmHg), decomposition starts slowly after five minutes; and
3) Cu(hfac)(α-MS) dissolves in hexane very sparsely, and in benzene, the compound dissolves very well, but slowly decomposes with the precipitation of copper after several days.

The NMR structural analysis was carried out on a QE 300 MHz NMR instrument. The results are as follows: $^1$H NMR ($C_6D_6$) δ 1.67 (*s*, 3, $(C_6H_5)(CH_3)C{=}CH_2$), 3.68 (*s*, 1, $(C_6H_5)(CH_3)C{=}CH_2$), 4.26 (*s*, 1, $(C_6H_5)(CH_3)C{=}CH_2$), 5.97 (*s*, 1, $(CF_3)C(O)CHC(O)(CF_3)$), 7.00 (*multi*. $(C_6H_5)(CH_3)C{=}CH_2$), 7.24 (*multi*. $(C_6H_5)(CH_3)C{=}CH_2$)

Fig. 5 is a flowchart illustrating a preferred method for synthesizing a copper(hfac) α - methylstyrene precursor. Step 150 provides $Cu_2O$. Step 152 forms a uniformly mixed solution of $Cu_2O$ and solvent. Step 152 includes using a solvent selected from the group consisting of dichloromethane and tetrahydrofuran (THF). Step 154 introduces α -methylstyrene to the solution of Step 152, and forms a uniformly mixed solution. Step 156 introduces hexafluoroacetylacetone to the solution of Step 154, and forms a uniformly mixed solution. Step 158 filters the solution to remove solid material in the solution, whereby excess $Cu_2O$ is removed. Step 158 includes filtering solids having a size greater than approximately 10 microns. Typically, Step 158 includes using celite to perform the solution filtering. Step 160 strips the solution of solvent. Step 162 filters the solution to remove solid material and crystallized compounds. Step 162 includes removing solid material and crystallized compounds having a size larger than approximately 1 micron. Step 164 is a product, where a liquid phase stable precursor is formed.

Specifically, Step 152 includes $Cu_2O$, in proportion, of 0.91 mol, Step 154 includes α - methylstyrene, in proportion, of 0.142 mol, and Step 156 includes the hfac, in proportion, of 0.136 mol.

In some aspects of the invention, a further step, follows Step 158, and precedes Step 162. Step 160a heats the solution to approximately 35 degrees C to aid in the stripping of solvent from the solution.

A new and improved copper precursor, and synthesis method for the copper precursor, has been disclosed above. The precursor, especially the α - methylstyrene ligand precursor, is stable a low temperatures, and sufficiently volatile at higher temperatures. Copper deposited with the precursor has low resistivity and high adhesive characteristics. Finally, the precursor is inexpensive to make. A synthesis method has been disclosed which produces a high yield of the above-described precursor.

## Claims

1. A volatile copper precursor compound for the chemical vapor deposition (CVD) of copper to a selected surface, the precursor compound comprising:

$Cu^{+1}$(hexafluoroacetylacetonate); and
a substituted phenylethylene ligand including ethylene having a first carbon atom bonded to a phenyl group and to a substituent selected from $C_1$ to $C_6$ alkyl, $C_1$ to $C_6$ haloalkyl, phenyl and $C_1$ to $C_6$ alkoxyl, and in which a second carbon atom bonded to second and third substituents selected from H, $C_1$ to $C_6$ alkyl, phenyl and $C_1$ to $C_6$ alkoxyl.

**2.** A volatile copper precursor compound for use in applying chemical vapor deposition (CVD) copper to a selected surface, the precursor compound having the following structural formula:

$$(hfac)Cu(C_6H_5)(R^1)C=C(R^2)(R^3)$$

in which

$R^1$ is selected from $C_1$ to $C_6$ alkyl, $C_1$ to $C_6$ haloalkyl, phenyl and $C_1$ to $C_6$ alkoxyl; and
each of $R^2$ and $R^3$ is selected from H, $C_1$ to $C_6$ alkyl, phenyl and $C_1$ to $C_6$ alkoxyl.

**3.** A Cu precursor according to claim 1 or claim 2, wherein the phenylethylene ligand is $\alpha$-methylstyrene.

**4.** A Cu precursor blend which comprises a Cu precursor according to any one of claims 1 to 3 and a substituted phenylethylene additive.

**5.** A Cu precursor blend according to claim 4, wherein the additive has the general formula

$$(C_6H_5)(R^1)C=C(R^2)(R^3)$$

in which
$R^1$, $R^2$ and $R^3$ have the meanings specified in claim 2.

**6.** A Cu precursor blend according to claim 5, wherein the substituted phenylethylene ligand and the substituted phenylethylene additive are the same.

**7.** A Cu precursor blend according to any one of claims 4 to 6, wherein the additive comprises less than approximately 10% by weight of the blend.

**8.** A method for synthesizing a copper(hfac) substituted phenylethylene precursor comprising the steps of:

(a) forming a uniformly mixed solution of $Cu_2O$ in a solvent;
(b) introducing a substituted phenylethylene to the solution of Step (a) and forming a uniformly mixed solution;
(c) introducing hexafluoroacetylacetone (hfac) to the solution of Step (b) and forming a uniformly mixed solution;
(d) filtering the solution to remove solid materials whereby any excess $Cu_2O$ is removed;
(e) removing the solvent from the solution;
(f) stirring until any crystallized precursor in the solution is dissolved;
(g) allowing the solution to stand until crystals form; and
(h) filtering to remove the solid material whereby a liquid phase precursor is formed.

**9.** A method according to claim 8, wherein in Step (b) the substituted phenylethylene is $\alpha$-methylstyrene.

**10.** A method according to claim 8 or claim 9, wherein in Step (a) the $Cu_2O$ is in proportion, 0.210 mol, in Step (b) the substituted phenylethylene is, in proportion, 0.292 mol, and in Step (c) the hfac is, in proportion, 0.292 mol.

**11.** A method according to any one of claims 8 to 10, wherein Step (g) includes allowing the solution stand until crystals having a size of 2 to 4 mm have formed.

**12.** A method according to any one of claims 8 to 11, wherein Step (h) includes filtering off solid material having a size greater than approximately 1$\mu$m.

**13.** A method according to any one of claims 8 to 12, comprising a further step, following Step (h), of:

(i) adding less than approximately 10% by weight of the substituted phenylethylene used in Step (b) to the solution whereby the liquid phase stability of the precursor is improved.

**14.** A method according to claim 13, wherein Step (i) includes adding approximately 5% substituted phenylethylene.

**15.** A method for synthesizing a copper(hfac) α-methylstyrene precursor comprising the steps of:

(a) forming a uniformly mixed solution of $Cu_2O$ and solvent;
(b) introducing α-methylstyrene to the solution of Step (a) and forming a uniformly mixed solution;
(c) introducing hexafluoroacetylacetone (hfac) to the solution of Step (b) and forming a uniformly mixed solution;
(d) filtering the solution to remove solid material whereby excess $Cu_2O$ is removed;
(e) stripping the solution of solvent; and
(f) filtering the solution to remove the solid material and crystallized compounds whereby a liquid phase stable precursor is formed.

**16.** A method according to claim 15, wherein in Step (a) the $Cu_2O$ is, in proportion, 0.91 mol, in Step (b) α-methylstyrene is, in proportion, 0.142 mol, and in Step (c) the hfac is, in proportion, 0.136 mol.

**17.** A method according to claim 15 or claim 16, wherein Step (f) includes removing solid material and crystallized compounds having a size larger than approximately 1 μm.

**18.** A method according to any one of claims 15 to 17, including a further step, following Step (d) and preceding Step (f), of:

($e_1$) heating the solution to approximately 35°C to aid in the stripping of solvent from the solution.

**19.** A method according to any one of claims 8 to 18, wherein Step (d) includes removing solid material larger than approximately 10 μm.

**20.** A method according to claim 19, wherein Step (d) uses celite to filter the solution.

**21.** A method according to any one of claims 8 to 20, wherein Step (a) uses a solvent selected from dichloromethane and tetrahydrofuran (THF).

**Patentansprüche**

**1.** Flüchtige Kupfervorläuferverbindung zur chemischen Dampfabscheidung (CVD) von Kupfer auf einer ausgewählten Fläche, wobei die Vorläuferverbindung Folgendes aufweist:

- $Cu^{+1}$(hexafluoracetylaceton); und
- einen substituierten Phenylethylenliganden mit Ethylen mit einem ersten, an eine Phenylgruppe gebundenen Kohlenstoffatom und einem Substituenten, der aus einem $C_1$- bis $C_6$-Alkyl, einem $C_1$- bis $C_6$-Haloalkyl, Phenyl und einem $C_1$- bis $C_6$-Alkoxyl ausgewählt ist, und wobei ein zweites Kohlenstoffatom mit einem zweiten und einem dritten Substituenten verbunden ist, die aus H, einem $C_1$- bis $C_6$-Alkyl, Phenyl und einem $C_1$- bis $C_6$-Alkoxyl ausgewählt sind.

**2.** Flüchtige Kupfervorläuferverbindung zur Verwendung beim Auftragen von Kupfer aus chemischer Dampfabscheidung (CVD) auf eine ausgewählte Fläche, wobei diese Vorläuferverbindung die folgende Strukturformel aufweist:

$$(hfac)Cu(C_6H_5)(R^1)C = C(R^2)(R^3)$$

wobei

- $R^1$ aus einem $C_1$- bis $C_6$-Alkyl, einem $C_1$- bis $C_6$-Haloalkyl, Phenyl und einem $C_1$- bis $C_6$-Alkoxyl ausgewählt ist; und
- sowohl $R^2$ als auch $R^3$ aus H, einem $C_1$- bis $C_6$-Alkyl, Phenyl und einem $C_1$- bis $C_6$-Alkoxyl ausgewählt sind.

**3.** Cu-Vorläufer nach Anspruch 1 oder Anspruch 2, bei dem der Phenylethylenligand $\alpha$-Methylstyrol ist.

**4.** Cu-Vorläufergemisch mit einem Cu-Vorläufer nach einem der Ansprüche 1 bis 3 und einem Zusatzstoff aus einem substituierten Phenylethylen.

**5.** Cu-Vorläufergemisch nach Anspruch 4, bei dem der Zusatzstoff die allgemeine Formel

$$(C_6H_5)(R^1)C = C(R^2)(R^3)$$

aufweist, wobei $R^1$, $R^2$ und $R^3$ die im Anspruch 2 angegebenen Bedeutungen haben.

**6.** Cu-Vorläufergemisch nach Anspruch 5, bei dem der substituierte Phenylethylenligand und der substituierte Phenylethylen-Zusatzstoff dieselben sind.

**7.** Cu-Vorläufergemisch nach einem der Ansprüche 4 bis 6, bei dem der Zusatzstoff weniger als ungefähr 10 Gewichtsprozent des Gemischs ausmacht.

**8.** Verfahren zum Synthetisieren eines Kupfer(hfac)-substituierten Phenylethylenvorläufers, mit den folgenden Schritten:

(a) Herstellen eines gleichmäßigen Lösungsgemischs von $Cu_2O$ in einem Lösungsmittel;
(b) Einleiten eines substituierten Phenylethylens in die Lösung aus dem Schritt (a) und Herstellen eines gleichmäßigen Lösungsgemischs;
(c) Einleiten von Hexafluoracetylaceton (hfac) in die Lösung aus dem Schritt (b) und Herstellen eines gleichmäßigen Lösungsgemischs;
(d) Filtern der Lösung zum Entfernen von Feststoffmaterialien, wodurch jegliches überschüssiges $Cu_2$ entfernt wird;
(e) Entfernen des Lösungsmittels aus der Lösung;
(f) Rühren, bis jeglicher kristallisierter Vorläufer in der Lösung aufgelöst ist;
(g) Stehenlassen der Lösung, bis sich Kristalle bilden; und
(h) Filtern zum Entfernen des Feststoffmaterials, wodurch ein Flüssigphase-Vorläufer gebildet wird.

**9.** Verfahren nach Anspruch 8, bei dem im Schritt (b) das substituierte Phenylethylen $\alpha$-Methylstyrol ist.

**10.** Verfahren nach Anspruch 8 oder 9, bei dem im Schritt (a) das $Cu_2$ anteilsmäßig mit 0,210 mol vorliegt, im Schritt (b) das substituierte Phenylethylen anteilsmäßig mit 0,292 mol vorliegt und im Schritt (c) das hfac anteilsmäßig mit 0,292 mol vorliegt.

**11.** Verfahren nach einem der Ansprüche 8 bis 10, bei dem es zum Schritt (g) gehört, dass die Lösung stehen kann, bis sich Kristalle mit einer Größe von 2 bis 4 mm gebildet haben.

**12.** Verfahren nach einem der Ansprüche 8 bis 11, bei dem es zum Schritt (h) gehört, Feststoffmaterial mit einer Größe über ungefähr 1 $\mu$m auszufiltern.

**13.** Verfahren nach einem der Ansprüche 8 bis 12, mit einem auf den Schritt (h) folgenden weiteren Schritt, bei dem:

(i) weniger als ungefähr 10 Gewichtsprozent des im Schritt (b) verwendeten substituierten Phenylethylens zur Lösung zugesetzt werden, wodurch die Flüssigphasenstabilität des Vorläufers verbessert wird.

**14.** Verfahren nach Anspruch 13, bei dem es zum Schritt (i) gehört, ungefähr 5 % an substituiertem Phenylethylen zuzusetzen.

**15.** Verfahren zum Synthetisieren eines Kupfer(hfac)-$\alpha$-Methylstyrolvorläufers, das die folgenden Schritte aufweist:

(a) Herstellen eines gleichmäßigen Lösungsgemischs von $Cu_2O$ in einem Lösungsmittel;
(b) Einleiten eines substituierten Phenylethylens in die Lösung aus dem Schritt (a) und Herstellen eines gleichmäßigen Lösungsgemischs;
(c) Einleiten von Hexafluoracetylaceton (hfac) in die Lösung aus dem Schritt (b) und Herstellen eines gleichmäßigen Lösungsgemischs;
(d) Filtern der Lösung zum Entfernen von Feststoffmaterialien, wodurch überschüssiges $Cu_2$ entfernt wird;
(e) Entziehen des Lösungsmittels aus der Lösung; und
(f) Filtern der Lösung zum Entfernen des Feststoffmaterials und kristallisierter Verbindungen, wodurch ein stabiler Flüssigphase-Vorläufer gebildet wird.

**16.** Verfahren nach Anspruch 15, bei dem im Schritt (a) das $Cu_2O$ anteilsmäßig mit 0,91 mol vorliegt, im Schritt (b) das α-Methylstyrol anteilsmäßig mit 0,142 Mol vorliegt und im Schritt (c) das hfac anteilsmäßig mit 0,136 mol vorliegt.

**17.** Verfahren nach Anspruch 15 oder Anspruch 16, wobei es zum Schritt (f) gehört, Feststoffmaterial und kristallisierte Verbindungen mit einer Größe von mehr als ungefähr 1 μm zu entfernen.

**18.** Verfahren nach einem der Ansprüche 15 bis 17, mit einem weiteren Schritt, der auf den Schritt (d) folgt und vor dem Schritt (f) liegt, mit:

($e_1$) Erwärmen der Lösung auf ungefähr 35°C, um das Entziehen des Lösungsmittels aus der Lösung zu unterstützen.

**19.** Verfahren nach einem der Ansprüche 8 bis 18, bei dem es zum Schritt (d) gehört, Feststoffmaterial über ungefähr 10 μm zu entfernen.

**20.** Verfahren nach Anspruch 19, bei dem im Schritt (d) Celit zum Filtern der Lösung verwendet wird.

**21.** Verfahren nach einem der Ansprüche 8 bis 20, bei dem im Schritt (a) ein aus Dichlormethan und Tetrahydrofuran (THF) ausgewähltes Lösungsmittel verwendet wird.

## Revendications

**1.** Composé précurseur de cuivre, volatil, pour le dépôt en phase vapeur par procédé chimique (CVD) de cuivre sur une surface sélectionnée, le composé précurseur comprenant :

de l'hexafluoroacétylacétonate de $Cu^{+1}$ ; et
un ligand phényléthylène substitué comprenant de l'éthylèn ayant un premier atome de carbone lié à un groupe phényle et à un substituant choisi parmi alkyle en $C_1$ à $C_6$, halogénoalkyle en $C_1$ à $C_6$, phényle et alcoxy en $C_1$ à $C_6$, et dans lequel un deuxième atome de carbone est lié à des deuxième et troisième substituants choisis parmi H, alkyle en $C_1$ à $C_6$, phényle et alcoxy en $C_1$ à $C_6$.

**2.** Composé précurseur de cuivre, volatil, à utiliser dans l'application de cuivre par le dépôt en phase vapeur par procédé chimique (CVD) sur une surface sélectionnée, le composé précurseur répondant à la formule structurelle suivante :

$$(hfac)Cu(C_6H_5)\ (R^1)C{=}C(R^2)\ (R^3)$$

dans laquelle

$R^1$ est choisi parmi alkyle en $C_1$ à $C_6$, halogénoalkyle en $C_1$ à $C_6$, phényle et alcoxy en $C_1$ à $C_6$ ; et
chacun de $R^2$ et $R^3$ est choisi parmi H, alkyle en $C_1$ à $C_6$, phényle et alcoxy en $C_1$ à $C_6$.

**3.** Précurseur de Cu selon la revendication 1 ou la revendication 2, dans lequel le ligand phényléthylène est l'α-méthylstyrène.

4. Mélange précurseur de Cu qui comprend un précurseur de Cu selon l'une quelconque des revendications 1 à 3 et un additif phényléthylène substitué.

5. Mélange précurseur de Cu selon la revendication 4, dans lequel l'additif répond à la formule générale :

$$(C_6H_5)(R^1)C{=}C(R^2)(R^3)$$

dans laquelle $R^1$, $R^2$ et $R^3$ ont les significations spécifiées dans la revendication 2.

6. Mélange précurseur de Cu selon la revendication 5, dans lequel le ligand phényléthylène substitué et l'additif phényléthylène substitué sont identiques.

7. Mélange précurseur de Cu selon l'une quelconque des revendications 4 à 6, dans lequel l'additif représente moins d'environ 10 % en poids du mélange.

8. Procédé pour synthétiser un précurseur phényléthylène substitués cuivre(hfac), comprenant les étapes consistant à :

(a) former une solution uniformément mélangée de $Cu_2O$ dans un solvant ;
(b) introduire un phényléthylène substitué dans la solution de l'étape (a), et former une solution uniformément mélangée ;
(c) introduire de l'hexafluoroacétylacétone (hfac) dans la solution de l'étape (b), et former une solution uniformément mélangée ;
(d) filtrer la solution pour éliminer les matières solides, grâce à quoi tout $Cu_2O$ en excès est éliminé ;
(e) éliminer le solvant de la solution ;
(f) agiter jusqu'à ce que tout précurseur cristallisé dans la solution soit dissous ;
(g) laisser la solution reposer jusqu'à ce que des cristaux se forment ; et
(h) filtrer pour éliminer les matières solides, grâce à quoi un précurseur en phase liquide est formé.

9. Procédé selon la revendication 8, dans lequel, dans l'étape (b), le phényléthylène substitué est l'$\alpha$-méthylstyrène.

10. Procédé selon la revendication 8 ou la revendication 9, dans lequel, dans l'étape (a), le $Cu_2O$ est présent en une proportion de 0,210 mole, dans l'étape (b), le phényléthylène substitué est présent en une proportion de 0,292 mole, et dans l'étape (c), le hfac est présent en une proportion de 0,292 mole.

11. Procédé selon l'une quelconque des revendications 8 à 10, dans lequel l'étape (g) comprend l'étape consistant à laisser la solution reposer jusqu'à ce que des cristaux ayant une taille de 2 à 4 mm soient formés.

12. Procédé selon l'une quelconque des revendications 8 à 11, dans lequel l'étape (h) comprend la séparation par filtration des matériaux solides ayant une taille supérieure à environ 1 $\mu$m.

13. Procédé selon l'une quelconque des revendications 8 à 12, comprenant une étape supplémentaire, suivant l'étape (h), consistant à :

(i) ajouter à la solution moins d'environ 10 % en poids du phényléthylène substitué utilisé dans l'étape (b), grâce à quoi la stabilité en phase liquide du précurseur est améliorée.

14. Procédé selon la revendication 13, dans lequel l'étape (i) comprend l'addition d'environ 5 % de phényléthylène substitué.

15. Procédé pour synthétiser un précurseur $\alpha$-méthylstyrène cuivre(hfac), comprenant les étapes consistant à :

(a) former une solution uniformément mélangée de $Cu_2O$ et de solvant ;
(b) introduire de l'$\alpha$-méthylstyrène dans la solution de l'étape (a) et former une solution uniformément mélangée ;
(c) introduire de l'hexafluoroacétylacétone (hfac) dans la solution de l'étape (b), et former une solution uniformément mélangée ;

(d) filtrer la solution pour éliminer le matériau solide, en conséquence de quoi le $Cu_2O$ en excès est éliminé ;
(e) éliminer le solvant de la solution ; et
(f) filtrer la solution pour éliminer les matières solides et les composés cristallisés, grâce à quoi un précurseur stable en phase liquide est formé.

**16.** Procédé selon la revendication 15, dans lequel, dans l'étape (a), le $Cu_2O$ est présent en une proportion de 0,91 mole, dans l'étape (b), l'$\alpha$-méthylstyrène est présent en une proportion de 0,142 mole, et dans l'étape (c), le hfac est présent en une proportion de 0,136 mole.

**17.** Procédé selon la revendication 15 ou la revendication 16, dans lequel l'étape (f) comprend l'élimination des matières solides et des composés cristallisés ayant une taille supérieure à environ 1 $\mu$m.

**18.** Procédé selon l'une quelconque des revendications 15 à 17, comprenant une étape supplémentaire, suivant l'étape (d) et précédant l'étape (f), consistant à :

($e_1$) chauffer la solution à environ 35°C pour faciliter l'élimination du solvant à partir de la solution.

**19.** Procédé selon l'une quelconque des revendications 8 à 18, dans lequel l'étape (d) comprend l'élimination des matières solides supérieurs à environ 10 $\mu$m.

**20.** Procédé selon la revendication 19, dans lequel l'étape (d) utilise de la Celite pour filtrer la solution.

**21.** Procédé selon l'une quelconque des revendications 8 à 20, dans lequel l'étape (a) utilise un solvant choisi parmi le dichlorométhane et le tétrahydrofurane (THF).

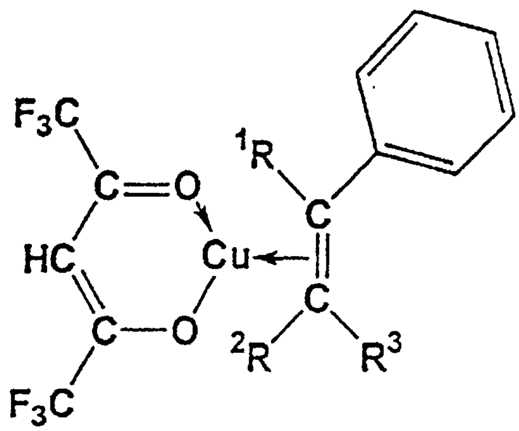

10

Fig. 1

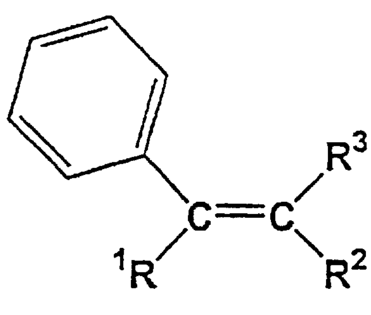

20

Fig. 2

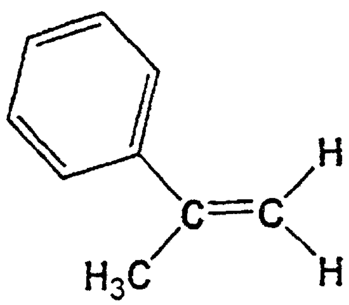

30

Fig. 3

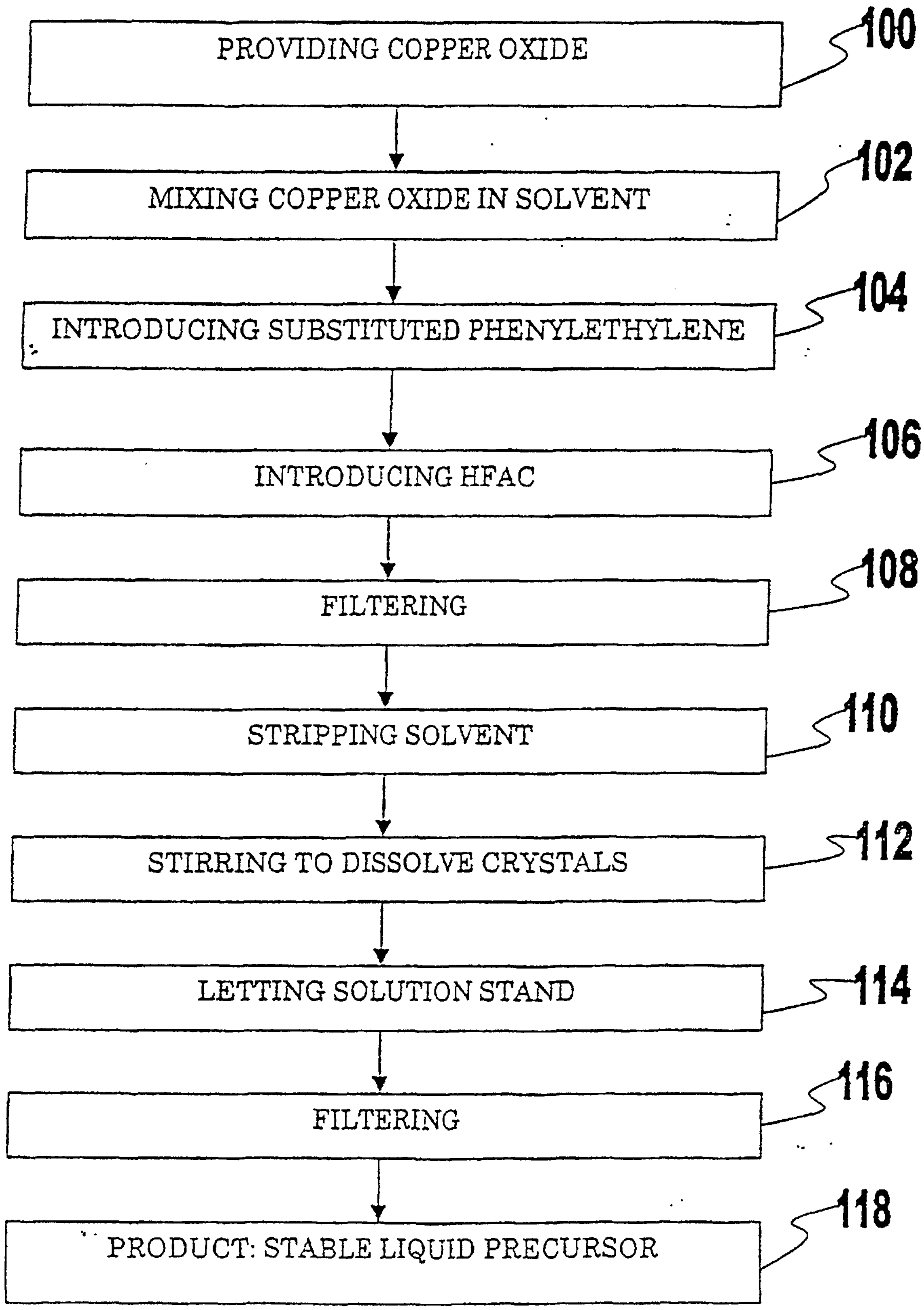
PROVIDING COPPER OXIDE
100
MIXING COPPER OXIDE IN SOLVENT
102
INTRODUCING SUBSTITUTED PHENYLETHYLENE
104
INTRODUCING HFAC
106
FILTERING
108
STRIPPING SOLVENT
110
STIRRING TO DISSOLVE CRYSTALS
112
LETTING SOLUTION STAND
114
FILTERING
116
PRODUCT: STABLE LIQUID PRECURSOR
118

Fig. 4

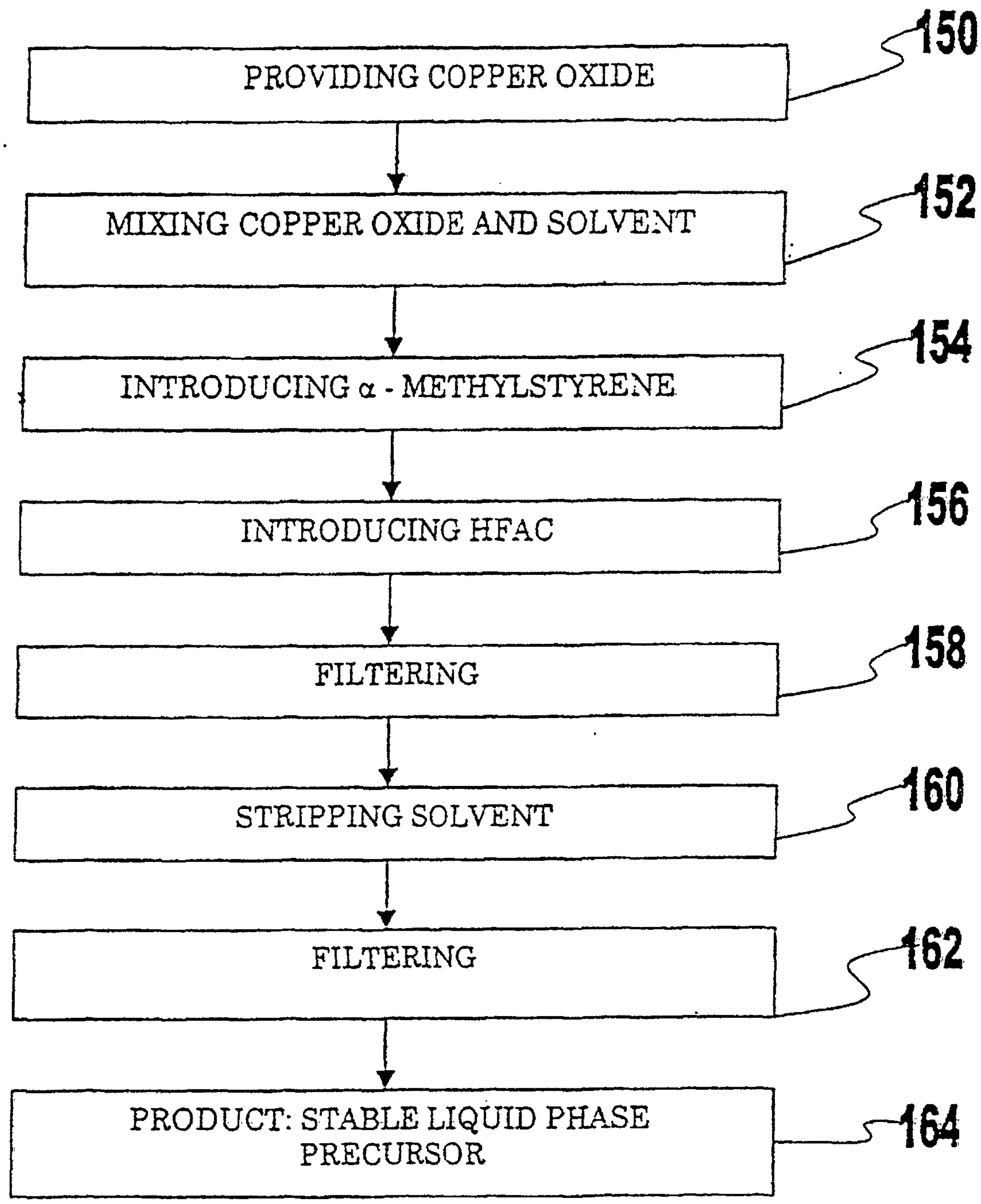
150
PROVIDING COPPER OXIDE
152
MIXING COPPER OXIDE AND SOLVENT
154
INTRODUCING α - METHYLSTYRENE
156
INTRODUCING HFAC
158
FILTERING
160
STRIPPING SOLVENT
162
FILTERING
164
PRODUCT: STABLE LIQUID PHASE PRECURSOR

Fig. 5